# EUROPÄISCHE PATENTSCHRIFT

(11) **EP 3 878 038 B1**
(45) Veröffentlichungstag und Bekanntmachung des Hinweises auf die Patenterteilung: **23.09.2026**
(21) Anmeldenummer: 19801795.6
(22) Anmeldetag: 05.11.2019
(51) Int. Cl.: H01M 8/0228

(54) **VERFAHREN ZUR HERSTELLUNG VON BIPOLARPLATTEN FÜR BRENNSTOFFZELLEN**
METHOD FOR PRODUCING BIPOLAR PLATES FOR FUEL CELLS
PROCÉDÉ POUR LA FABRICATION DE PLAQUES BIPOLAIRES POUR PILES À COMBUSTIBLE

(30) Priorität: 08.11.2018 DE 102018219056
(43) Veröffentlichungstag der Anmeldung: 15.09.2021
(73) Patentinhaber: Fraunhofer-Gesellschaft zur Förderung der angewandten Forschung e.V., 80686 München (DE); Technische Universität Dresden, 01069 Dresden (DE)
(72) Erfinder: BEYER, Eckhard, 01277 Dresden (DE); ROCH, Teja, 01277 Dresden (DE)
(74) Vertreter: Pfenning, Meinig & Partner mbB
(86) Internationale Anmeldenummer: PCT/EP2019/080211
(87) Internationale Veröffentlichungsnummer: WO 2020/094627

(56) Entgegenhaltungen:
- DE-A1- 102004 016 318
- DE-A1- 102008 064 085
- DE-A1- 102016 125 502
- DE-A1- 102017 202 679
- TAHERIAN REZA: "A review of composite and metallic bipolar plates in proton exchange membrane fuel cell: Materials, fabrication, and material selection", JOURNAL OF POWER SOURCES, ELSEVIER SA, CH, vol. 265, 29 May 2014 (2014-05-29), pages 370 - 390, XP028851118, ISSN: 0378-7753, DOI: 10.1016/J.JPOWSOUR.2014.04.081

## Beschreibung

Die Erfindung betrifft ein Verfahren zur Herstellung von Bipolarplatten für Brennstoffzellen, insbesondere sind dies Brennstoffzellen bei denen an einer Seite mindestens einer der zwei Elektroden von Brennstoffzellen eine Bipolarplatte angeordnet und mit einer Membran-Elektroden-Anordnung verbindbar ist, wobei die einen Elektrolyten bildende Membran eine Polymermembran ist.

Brennstoffzellen dienen beispielsweise der Stromerzeugung in mobilen Anwendungen durch Wandlung chemischer Energie in Elektroenergie. Aktuell ist die Herstellung der Brennstoffzellen noch kostenintensiv, so dass ihre Anwendung beispielsweise im automobilen Sektor noch nicht wirtschaftlich umgesetzt werden kann. Bipolarplatten (BIP) dienen in der Brennstoffzelle der Zufuhr von Wasserstoff, Sauerstoff und der Ableitung von Wasser, Kühlwasser sowie dem Zuleiten und Abgreifen von freiwerdenden Elektronen. Zwischen zwei Bipolarplatten sind eine Anode (Wasserstoffzufuhr) und eine Kathode (Sauerstoffzufuhr und Wasserabtransport) zwischen denen eine Polymermembran (Polymer Electrolyte Membrane - PEM) mit einer beispielsweise Platin als Katalysator enthaltenden Elektrodenbeschichtung bzw. Katalysatorschichten und die Gasdiffusionsschicht angeordnet. Sie bilden eine sogenannte Membran-Elektroden-Anordnung MEA (Membrane Electrode Assembly). Zusätzlich sind noch entsprechende Dichtungen auf die Bipolarplatte aufgebracht. Dies geschieht typischerweise bevor die MEA aufgebracht wird. Die PEM ist eine elektrisch isolierende aber Protonen leitende Polymermembran. Dadurch können Wasserstoffionen hindurch diffundieren und elektrischer Strom kann über einen Verbraucher zur Kathode geleitet werden. Die Elektrodenschichten werden typischerweise auf die PEM heiß gepresst. Zwischen den Bipolarplatten und der Membran/Elektrode sind sogenannte Gasdiffusionsschichten (GDL), ein Gewirk z. B. aus Kohlefasern, das den Zweck hat, die aus den Kanälen der BiP austretenden Gase vollflächig und homogen auf der Membran zu verteilen und die vom Wasserstoff abgegebenen Elektronen an die jeweilige Bipolarplatte weiterzuleiten bzw. von dort wegzuleiten, angeordnet.

Die Brennstoffzelle erreicht typischerweise zwischen den beiden Elektroden eine Spannung von beispielsweise 0,5 V - 1,23 V. Durch Verluste liegt die elektrische Nutzspannung jedoch typischerweise niedriger. Es ist wichtig, dass die frei werdenden Elektronen auf der Wasserstoffseite möglichst effizient aufgenommen und auf der Sauerstoffseite dem Prozess wieder möglichst effizient zugeführt werden. Es sollen dabei möglichst geringe Kontakt- oder Durchtrittswiderstände auftreten. Ein elektrischer Widerstand an dieser Stelle hat direkten Einfluss auf die Effizienz der BIP. Die Betriebstemperatur wird hierbei in einem für den Zelltyp optimalen Bereich von beispielsweise < 100 °C gehalten. Die hierfür notwendige Kühlung kann über einen Kühlkreislauf innerhalb der Bipolarplatte realisiert werden.

Bei der Fertigung solcher Brennstoffzellen wird bisher beginnend bei einem gewalzten Stahl- oder Titanblech (Dicke 0,05 mm - 0,2 mm) aus diesem Blech eine BIP Halbschale gefertigt. Dafür wird das Blech bspw. ausgeschnitten und mittels eines ein- oder mehrstufigen Prägeverfahrens umgeformt. Anschließend wird diese Halbschale mit einer zweiten Halbschale zu einer BIP gefügt.

Die Halbschalen können dabei unterschiedliche Geometrien an Kathoden- und Anodenseite aufweisen. Das Fügeverfahren bei Edelstahl BIP ist typischerweise ein Laserschweißprozess. Bei Titan kommen auch klebende Fügeverfahren zum Einsatz. Nach dem Fügen der Platten werden diese beidseitig Oberflächenbeschichtet. Dies kann beispielsweise ein Schichtsystem sein, das mit einer Kohlenstoffschicht endet.

Auf die BIP wird anschließend eine Dichtung aufgebracht, was bspw. über ein Spritzverfahren erreicht werden kann. Sie wird dann ausgehärtet. Alternativ kann auch eine vorgefertigte Dichtung aufgelegt werden. Danach erfolgt das Aufbringen der MEA. Durch Stapelung derartiger BIP + MEA werden Brennstoffzellen bzw. Brennstoffzellenstapel gebildet. Teilweise gibt es bei dem dargestellten Verfahren noch Zwischenschritte bspw. zur Qualitätssicherung. Diese Prüfung umfasst auch die Prüfung der Dichtheit einzelner Zellen bzw. abschließend auch des gesamten Zellenstapels.

So sind aus DE 10 2017 202 679 A1 eine Bipolarplatte für elektrochemische Zellen mit einem entsprechenden Herstellungsverfahren bekannt.

DE 10 2016 125 502 A1 betrifft eine Vorrichtung und ein Verfahren zur Herstellung von Bipolarplatten.

Von R. Tahrian ist in "A review of composite and metallic bipolar plates proton exchange membrane fuel cell: Materials, fabrication, and material selection"; Journal of Power Sources, Elesevir SA; CH; Bd. 265; 29. Mai 2014; S. 370-390; XP028851118; ISSN:0378-7753; DOI: 10.1016/J.JPOWSOUR.2014.04.081 Bipolarplatten als Kernkomponente von Brennstoffzellen beschrieben.

Es ist daher Aufgabe der Erfindung, Möglichkeiten für die Erhöhung der Arbeitsproduktivität bei der Herstellung von Bipolarplatten für Brennstoffzellen anzugeben.

Erfindungsgemäß wird diese Aufgabe mit einem Verfahren, das die Merkmale des Anspruchs 1 aufweist, gelöst. Vorteilhafte Ausgestaltungen und Weiterbildungen der Erfindung können mit in untergeordneten Ansprüchen bezeichneten Merkmalen realisiert werden.

Eine Verbesserung ist dabei der Ansatz zur Fertigung von Brennstoffzellen, bei der die gesamte Fertigung in einer Prozesskette bzw. in einem Bandverfahren durchgeführt werden kann. Dafür sollten möglichst viele Produktionsschritte im Bandverfahren durchgeführt werden und eine Vereinzelung des Bandes in BIP oder BIP + GDL oder BIP + MEA möglichst spät in der Prozesskette erfolgen. In diesem Fall handelt es sich um ein Rolle zu Platte Verfahren. Aus derart vereinzelten BIP kann am Ende der Prozesskette ein ganzer Brennstoffzellenstapel bestehend aus einer Vielzahl gestapelter BIP + MEA und entsprechender Dichtungstechnik sowie Endstücken aufgebaut werden.

Bei dem Verfahren kann ein Metallband oder es können zwei Metallbänder durch eine erste Vorrichtung, die zur Vorreinigung des Metallbandes oder der zwei Metallbänder ausgebildet ist, hindurch geführt werden, wenn eine Vorreinigung erforderlich ist.

Im Anschluss an die ggf. durchgeführte Vorreinigung wird das eine Metallband oder werden die zwei Metallbänder durch eine zweite Vorrichtung und/oder eine dritte Vorrichtung geführt. Die zweite Vorrichtung ist zur Durchführung einer Feinreinigung und/oder einer Nitrierung des Metallbandes und die dritte Vorrichtung ist zur Durchführung einer Oberflächenbeschichtung an einer Seite einer Oberfläche mit einer eine Haftung verbessernden Metallschicht ausgebildet.

Auf die so behandelte Oberfläche wird eine Kohlenstoffschicht in einer vierten Vorrichtung aufgebracht.

Im Anschluss daran kann bei der Vorschubbewegung des einen so vorbehandelten Metallbandes eine bevorzugt mittige Teilung in Vorschubachsrichtung und Drehung eines der geteilten Metallbänder um 180 ° durchgeführt werden.

Werden zwei Metallbänder eingesetzt und so vorbehandelt, kann eine Drehung eines der zwei so vorbehandelten Metallbänder um 180 ° erforderlich sein.

Wiederum im Anschluss an die ggf. durchgeführte Teilung und/oder Drehung oder direkt im Anschluss an die Ausbildung der Kohlenstoffschicht wird eine Umformung Metallbänder durchgeführt, bei der Kanäle für die Zufuhr von Brennstoff und Oxidationsmittel sowie die Abfuhr von Reaktionsprodukten der elektrochemischen Reaktionen ausgebildet werden. Diese umgeformten Bänder sind damit nicht mehr planar sondern weisen eine dreidimensionale Oberflächenstruktur mit Erhebungen und/oder Vertiefungen auf. Es können Kanalbreiten im Bereich von beispielsweise 0,1 mm - 2 mm und Kanaltiefen von 0,05 - 1,5 mm erreicht werden. Derart umgeformte Bänder können auch Durchbrüche und damit keine geschlossene Oberfläche beispielsweise im Bereich der Kanalstruktur aufweisen. Hierbei kann die Kanalstruktur auch als Gitterstruktur ausgeprägt sein.

Die umgeformten Metallbänder werden so aufeinander zu bewegt und positioniert, dass Oberflächenbereiche in denen eine stoffschlüssige Fügung erfolgen soll, in berührenden Kontakt miteinander gelangen und die Fügung mit mindestens einem Laserstrahl, der in einen Spalt zwischen den aufeinander zu bewegten umgeformten Metallbänder gerichtet und nur dort eine Schweißverbindung ausgebildet wird. Dieser Schweißprozess kann auch mit einem Schweißprozess kombiniert werden, bei dem aus Richtung eines der Metallbänder dieses und das zweite Metallband in Form einer Schweißverbindung zusammengefügt wird.

Dabei sollten die einzelnen Schritte der Vorbehandlung in den Vorrichtungen, ggf. Teilung und Drehung sowie Umformung und Fügung nacheinander in einem kontinuierlichen Durchlaufprozess durchgeführt werden.

Vor einer Beschichtung eines Metallbandes sollte dieses gereinigt werden, da sich vom Walzprozess des Metallbandes noch Ölreste auf diesem befinden können. Die Reinigung kann grundsätzlich über nasschemische Verfahren erfolgen.

Befinden sich nur sehr dünne Ölfilme auf der Oberfläche, so kann die Reinigung auch in Form einer Verkohlung des restlichen Öles und gleichzeitiger Vorwärmung des Bandes geschehen. Die Temperaturen hierfür liegen beispielsweise bei ca. 150 °C. So können beispielsweise bei einer Wärmebehandlung Kohlenwasserstoffverbindungen oxidiert und dann die Oxidationsprodukte entfernt werden.

Sollte bereits gereinigtes oder ölfreies Metallband vorliegen, so kann ggf. auch auf eine Vorreinigung verzichtet werden.

Nach der Vorreinigung und gleichzeitigen Vorwärmung des einen Metallbandes oder der zwei Metallbänder erfolgt eine Nitrierung und/oder Plasmafeinreinigung an den Oberflächen. Hierfür sollte das Metallband oder die zwei Metallbänder auf Temperaturen von 320 °C - 450 °C erwärmt werden. Die Plasmafeinreinigung kann hierbei vorteilhaft in Kombination mit einer Nitrierung durchgeführt werden, wobei erst eine Plasmafeinreinigung durchgeführt werden kann, bevor Stickstoff für eine Nitrierung zugeführt wird. Beim Verzichten auf eine Plasmafeinreinigung in Kombination mit einer Nitrierung könnte die pro Zeit erreichbare Nitriertiefe verringert sein.

Das Plasmanitrieren ist eine thermochemische Behandlung der Oberfläche insbesondere von Stählen mit z.B. Stickstoff und wird normalerweise zur Verbesserung der Verschleißeigenschaften eingesetzt. Bei niedrigen Nitriertemperaturen kann jedoch zusätzlich auch die Korrosionsbeständigkeit verbessert werden. Kritisch für das Erreichen großer Nitriertiefen sind hierbei insbesondere die langen notwendigen Nitrierzeiten. Diese sind bei der Erfindung aber nicht erforderlich.

Zur reinen Verbesserung der Haftung einer nachfolgenden Kohlenstoffbeschichtung und Schaffung eines randnahen Nitrierbereiches reichen jedoch auch kurze Nitrierzeiten mit entsprechend verringerten Nitriertiefen von beispielsweise wenigen µm aus. Alternativ kann auf die Nitrierung auch verzichtet und durch beispielsweise einen Sputterprozess oder anderen Beschichtungsprozess ersetzt werden. Ein solcher Sputterprozess kann als Metallionensputtern ausgeführt werden, indem beispielsweise Chromionen mittels eines Lichtbogenprozesses erzeugt und auf die zu beschichtende Oberfläche beschleunigt werden. So kann eine die Haftung und den Korrosionsschutz verbessernde Chromschicht ausgebildet werden.

Nachfolgend und als letzten Beschichtungsprozess wird eine Kohlenstoffschicht mit einer Schichtdicke <200 nm vorzugsweise aber < 50 nm auf das Metallband oder die zwei Metallbänder in der vierten Vorrichtung aufgebracht. Hierbei sollte das Metallband oder die Metallbänder auf einer Temperatur T >300 °C gehalten sein und die Kohlenstoffionen in Oberflächen des Metallbandes oder der Metallbänder implantiert werden.

Nach dem Beschichtungsprozess wird das eine Metallband in mindestens zwei Metallbänder geteilt von denen eines zur Anodenseite der BIP und das andere zur Kathodenseite der jeweiligen BIP wird. Eines der durch die Teilung erhaltenen Metallbänder wird dann um 180 ° gedreht. Alternativ können die zwei Metallbänder auch schon vor der Beschichtung geteilt vorliegen und in derselben oder in zwei unterschiedlichen Anlagen beschichtet werden. In diesem Fall erfolgt keine Bandteilung. Da die Beschichtung der zwei Metallbänder typischerweise von unten erfolgt, sollte eines dieser beiden Metallbänder, aus denen eine BIP-Halbschale geformt wird, vor dem Umformprozess um 180 ° gewendet werden. Dies kann ebenfalls inline erfolgen. Bevorzugt erfolgt die Vorbehandlung zweier Metallbänder so, dass die zwei Metallbänder in paralleler Ausrichtung zueinander und mit gleicher Geschwindigkeit durch die Vorrichtungen und eine Einrichtung zur Drehung eines von zwei Metallbändern bewegt werden, wobei bevorzugt diese Geschwindigkeit auch bei der Umformung und einer danach durch zu führenden Fügung beibehalten werden sollte.

Alternativ kann die Bandführung während der Beschichtung auch vertikal erfolgen. In diesem Fall könnte ein Metallband beispielsweise beidseitig beschichtet oder die beiden Seiten des Metallbandes an Vorder- und Rückseite in unterschiedlichen Bereichen, so dass auf eine Drehung des Metallbandes um 180 ° vor dem Umformen oder Fügen verzichtet werden kann.

Der Umformprozess der Metallbänder kann durch unterschiedliche bekannte Verfahren wie dem Tiefziehen, Walzprägen, Prägen, Stanzen oder wirkmedienbasierte Umformverfahren beispielsweise ausgeführt als Hydroforming realisiert werden. Hierzu kann mindestens ein Umformwerkzeug beispielsweise in Form einer Prägewalze oder eines Prägestempels ausgeführt sein. Im Gegensatz zum Walzen oder Tiefziehen ist beim Hydroforming nur jeweils ein Prägewerkzeug, in Form jeweils einer Matrize, für die Kathoden- und Anodenseite notwendig.

Beim Hydroforming wird auf der Blechseite, die der Matrize zugewandt ist, ein Wirkmedium zugeführt, dass das Metallband an die Kontur der Matrize anpresst, dies kann grundsätzlich auch mehrstufig geschehen.

Beim Walzprägen sollten mindesten zwei Walzen eines Walzenpaares, eines für die Kathodenseite und eines für die Anodenseite eingesetzt werden. Ein Walzenpaar kann aus einer Matrize und einer Patrize als Walzen bestehen, deren radial äußere Oberfläche entsprechend strukturiert worden sind. Für einen mehrstufigen Umformprozess können jeweils auch mehrere Walzenpaare in Reihe hintereinander angeordnet sein. Der Umformprozess für eine Anodenseite und für eine Kathodenseite sollte synchron in einem Bandlauf durchgeführt werden. Die Prägestrukturen für Kathoden- und Anodenseite sind hierbei typischerweise unterschiedlich.

Bei nicht kontinuierlichen Umformverfahren und einer darauffolgenden kontinuierlichen Weiterbearbeitung beispielsweise mittels Laserschweißen, sollte die Möglichkeit geschaffen werden vor und nach dem Umformen Bandspeicher beispielsweise in Form von Schleifen, die die Wegstrecke des Metallbandes zwischen der Beschichtung bzw. Bandteilung und der Umformung oder auch der Umformung und dem Laserschweißen variieren können, vorzusehen. Dies bietet für alle beschriebenen Umformverfahren den Vorteil im Bereich des Laserschweißens die umgeformten Metallbänder passgenau fügen zu können. Passgenau bedeutet hierbei, dass zu fügende Positionen des Metallbandes so zusammengeführt und so zueinander positioniert werden, dass sie in berührenden Kontakt zueinander gelangen.

Mit mindestens einem Laserstrahl können aus Richtung einer der beiden Metallbänder mindestens im Randbereich der Bipolarplatte und der Medienzufuhr die Metallbänder an deren äußeren Rändern umsäumend gefügt werden.

Die Umformung der vorbehandelten Metallbänder sollte vorteilhaft so durchgeführt werden, dass stoffschlüssig mit Laserstrahlung zu fügende Bereiche der Metallbänder entweder nicht oder so umgeformt werden, dass diese Oberflächenbereiche im Anschluss an die durchgeführte Umformung bei der Fügung so zueinander positioniert werden, dass sie in berührenden Kontakt zueinander gelangen und vor der Fügung unter einem Winkel aufeinander zulaufen, so dass ein Spalt zwischen den zu fügenden umgeformten Metallbändern ausgebildet ist, in den der mindestens eine Laserstrahl auf die zu fügenden Oberflächenbereiche gerichtet werden kann. Mit dem mindestens einen Laserstrahl kann in diesen Bereichen eine dichte stoffschlüssige Verbindung durch Schweißen hergestellt werden. Hierbei sollte der Wärmeeintrag durch den Laserstrahl minimiert werden, um thermischen Verzug der BIP zu minimieren.

Für einen Laserschweißprozess können jeweils Vorrichtungswalzen oder auch Umformwalzen mit geometrischen Strukturen eingesetzt werden, wie sie beim Umformprozess auf der Seite, die der Beschichtung auf dem einen Metallband oder den zwei Metallbändern zugewandt war, eingesetzt werden. Bei einem mehrstufigen Prägeprozess können die Walzen auch unterschiedlich zu den vorher verwendeten Prägewerkzeugen an ihren zur Umformung genutzten Oberflächen ausgebildet sein. Die Vorrichtungswalzen sollten an Positionen, an denen eine Schweißnaht oder ein Schweißpunkt ausgebildet werden soll(en), jeweils eine Erhebung aufweisen.

Die beiden Vorrichtungswalzen können dabei nicht als Patrize und Matrize ausgebildet sein.

Bei einer Schweißung an den zu fügenden vorbehandelten und umgeformten Metallbändern sollte es zu keiner Verletzung der funktionalen Beschichtung auf der BIP kommen. Dazu sollte eine Schweißnaht oder ein Schweißpunkt innerhalb einer BIP angeordnet sein. Dadurch kann die korrosionsmindernde Wirkung der Beschichtung an den Schweißstellen nicht herabgesetzt werden.

Falls notwendig kann eine zusätzliche umsäumende Schweißung der Bipolarplatte und an Positionen der Materialzufuhr kann ggf. auch nachfolgend als überlappende Schweißung durchgeführt werden. Hierbei kann auch die Beschichtung verletzt werden.

Nach dem Fügen der BIP-Halbschalen können diese entweder vereinzelt oder in einem Bandverfahren, bevorzugt zur Fertigstellung vollständiger Brennstoffzellen weiterbearbeitet werden.

Dabei können die Halbzeuge in beschichteter, umgeformter und miteinander stoffschlüssig verbundener Form gleich vereinzelt und nachfolgend zu Brennstoffzellen weiter prozessiert werden.

Vor einer Vereinzelung, die mit einem Trennverfahren, wie beispielsweise einem Laserschneidprozess, durchgeführt werden kann, kann auch eine Abdichtung und ggf. können auch die Werkstoffe einer MEA einzeln oder eine vollständige MEA auf eine BIP aufgebracht werden. Auch diese Verfahrensschritte können in den erfindungsgemäßen Herstellungsprozess mit einbezogen werden.

Für die Herstellung können auch Metallbänder eingesetzt werden, die unterschiedliche Dicken aufweisen. Dadurch kann Einfluss auf die Festigkeit und die Betriebsbedingungen, insbesondere die lokal unterschiedlichen thermischen Verhältnisse an Brennstoffzellen genommen werden.

Beispielhaft kann eine BIP folgendermaßen mit den nachfolgend beschriebenen einzelnen Verfahren hergestellt werden:
Die Laserschweißung zum Fügen der vorbehandelten und umgeformten Metallbänder kann z. B. mittels eines IR (Wellenlänge z.B. 1000 nm - 1100 nm) single mode Faserlasers durchgeführt werden. Zwischen Laserquelle und Oberfläche kann der Laserstrahl über eine Faser geführt, am Ende der Faser kollimiert und über einen Scanner mit mindestens einem reflektierenden Element ausgelenkt werden. Der Scanner kann z.B. als Galvo-Scanner mit zwei reflektierenden Elementen ausgeführt sein. Der Laserstrahl kann anschließend mittels einer f-theta Optik fokussiert werden. Die Fokusbreite liegt typischerweise bei 10 µm - 200 µm.

Beim Metalionensputtern zur Feinreinigung in einer zweiten Vorrichtung kann die Oberfläche eines oder mehrerer zumindest vorgereinigter Metallbänder durch Beschuss von Ionen mit ausreichender Energie (10² eV bis mehreren 10³ eV) teilweise abgetragen werden. Dem zugrunde liegt ein Impulsübertrag des jeweiligen auftreffenden Ions mit der Oberfläche. Durch elastische "Kernstöße" wird dabei der Impuls in den Werkstoff an der Oberfläche des jeweiligen Metallbandes eingebracht und initiiert eine Stoßkaskade. Dadurch können Oberflächenatome einen nach außen gerichteten Impuls erhalten. Liegt die kinetische Energie der einfallenden Ionen über der Bindungsenergie der Werkstoffatome des jeweiligen Metallbandes, werden diese vorwiegend atomar, aber auch in Form von Atomclustern, von der Festkörperoberfläche zerstäubt.

Durch Anlegen einer elektrischen Hochspannung im Bereich zwischen 100 V und 1000 V an das jeweilige Metallband, idealerweise in einer Vakuumkammer einer zweiten Vorrichtung im Druckbereich von 10⁻³ mbar - 10² mbar, kann ein Niederdruckplasma mit Hilfe von Edelgasen generiert werden. Mit einer Mischung von angeregten Metall- und Gasionen werden die hochenergetischen Teilchen durch das angelegte elektrische Strompotential in Richtung des Substrates beschleunigt und tragen die Oberfläche ab. Hierdurch kann eine Plasmafeinreinigung des Substrats realisiert und die Metallbandoberflächenrauheit erhöht werden.

Bei einer potentialfreien Feinreinigung werden die Metallionen über zusätzliche Elektroden auf die Oberfläche eines jeweiligen Metallbandes beschleunigt. Alternativ kann auch an der Metallionenquelle ein elektrisches Potential anliegen.

Die Metallisierung metallischer Oberflächen zur Passivierung ist an sich bekannt. So werden z.B. Metalloberflächen verzinkt oder verchromt, um sie langfristig vor Korrosion zu schützen. In einer Brennstoffzelle treten zum Teil, je nach Fahrzustand, hohe Redoxpotentiale auf, die eine sehr aggressive Umgebung erzeugen. Werden metallische BIP verwendet, können diese korrodieren. Das Ziel bei einer metallischen BIP ist es, die Korrosionsbeständigkeit zu erhöhen und eine gute elektrische Leitfähigkeit zu erreichen.

Die Korrosionsbeständigkeit kann durch eine korrosionssmindernde Beschichtung oder ein Nitrieren des Metallbandes erreicht bzw. verbessert werden.

Das Plasmanitrieren ist eine thermochemische Behandlung der Oberfläche von Stählen, mit z.B. Stickstoff bei Temperaturen von ca. < 550° C. Es wird normalerweise zur Verbesserung der Verschleißeigenschaften verwendet. Speziell bei nichtrostenden Stählen geht durch das Abbinden von Chrom zu Chromnitrid (CrN) die passivierende Wirkung des Chroms verloren. Die Korrosionsbeständigkeit sinkt somit. Durch das Plasmanitrieren bei tieferen Temperaturen < 420 °C kann die Bildung von CrN größtenteils vermieden werden und die Korrosionsbeständigkeit kann sogar verbessert werden. Das Einbringen von Stickstoffatomen in den oberflächennahen Bereich der Metallbänder führt hierbei zu einer Gittererweiterung der kubischen austenitischen Atomstruktur. Hierzu wird in einer Unterdruck Stickstoffatmosphäre bei Drücken von ca. 0,1 Pa der Stickstoff ionisiert und in Richtung auf das Metallband beschleunigt.

Die Verbesserung der elektrischen Leitfähigkeit kann durch eine Abscheidung eines kohlenstoffbasierten, graphitähnlichen Schichtsystems in einer vierten Vorrichtung erreicht werden.

Durch Abscheidung mittels einer nicht gepulsten oder gepulsten Kohlenstoffionenquelle , z.B. einer Lichtbogenverdampfung eines Kohlenstofftargets in einer Vakuumkammer, können elektrisch leitfähige, korrosionsbeständige Schichten abgeschieden werden. Bei gleichzeitiger Erhöhung vor allem der Temperatur bei der Kohlenstoffabscheidung bilden sich weniger metastabile sp³-Bindungen und vermehrt sp²-Bindungen des Kohlenstoffs in der Schicht aus. Die erzeugten Kohlenstoffionen sollten dabei über eine Potentialdifferenz (> 400 V) zwischen Metallband und Kohlenstoffverdampfer oder beschleunigt über Hilfselektroden, auf hohe mittlere Ionenenergien >100 eV idealerweise ca. 300 eV beschleunigt werden, um so eine Implantation der Kohlenstoffionen zu erreichen.

Durch das Carburieren, mittels nachträglicher Einbringung von Kohlenstoff, kann nicht nur die Korrosionsbeständigkeit sondern auch die elektrische Leitfähigkeit erhöht werden. Der Werkstoff der Metallbänder, mit denen die BIP hergestellt werden, kann dadurch einen niedrigeren elektrischen Kontaktwiderstand aufweisen. Bei Drücken im Bereich von 0,01 Pa - 10 Pa wird durch ionisiertes Gas oder Plasma eine Oberflächenmodifikation erreicht. Zur Plasmaerzeugung kann dazu im Vakuum zwischen einer Kathode und einer Anode in einer zweiten Vorrichtung oder einer weiteren Vorrichtung, die in Vorschubrichtung des jeweiligen Metallbandes vor der vierten Vorrichtung angeordnet ist, eine elektrische Spannung von mehreren hundert Volt angelegt werden. In Abhängigkeit von der elektrischen Leitfähigkeit mindestens eines eingesetzten Kohlenstoff enthaltenden Gases ergibt sich bei angelegter elektrischer Spannung eine bestimmte elektrische Stromdichte. Durch Hilfsanoden erfahren die freien Elektronen, die von einer Elektronenquelle mittels Bogenentladung frei gesetzt werden, eine zusätzliche Beschleunigung und eine Intensivierung des Plasmas kann erreicht werden. Als Kohlenstoff enthaltende Gase kann man bevorzugt Kohlendioxid, Methan, Propan oder Kohlenstoff enthaltende Gasgemische aus beispielsweise Wasserstoff, Stickstoff und Kohlenmonoxid einsetzen.

Mit einer Carburierung kann eine Verminderung des Korrosionsschutzes im Bereich der Laserschweißnaht vermieden werden.

Bei dem erfindungsgemäßen Verfahren können Oberflächen eines Metallbandes oder zweier Metallbänder auch carbonitriert werden.

Das Bandhandling kann durch das Bandverfahren und die Verwendung von Walzen zur Fixierung der Metallbänder beim Fügen vereinfacht werden.

Der Wärmeeintrag durch das Fügen und damit thermischer Verzug der BiP kann minimiert werden, da einerseits die Walzen Wärme abführen können und die Schweißnähte oder -punkte feiner ausgeführt werden können.

Durch den beschriebenen Lösungsweg müssen die Metallbänder mit Kohlenstoffbeschichtung nicht mehr nach dem Beschichten aufgewickelt werden (Verminderung von Schädigungen) und mögliche Kontaminationen können verhindert werden. Dabei kann das eine Metallband oder die beiden Metallbänder können von einer Rolle abgerollt und ggf. über Umlenkrollen geführt werden. Die Vorschubbewegung kann mittels Antriebsrollenpaaren zumindest unterstützt werden. Die Vorschubbewegung kann auch allein von Walzenpaaren für die erwähnte Umformung erreicht werden.

Die erforderlichen Prozesszeiten können minimiert und Kontaminationen der Materialien oder Bauteile durch den Transport vermieden werden vermieden.

Brennstoffzellen mit erfindungsgemäß hergestellten BIP können in der Automobil-, Flugzeug-, Transportindustrie oder mobilen Anwendungen eingesetzt werden.

Nachfolgend soll die Erfindung beispielhaft näher erläutert werden.

Dabei zeigen:
- Figur 1: in schematischer Form ein Beispiel für die Durchführung des erfindungsgemäßen Verfahrens und
- Figur 2: eine Möglichkeit zum Fügen zweier vorbehandelter Metallbänder.

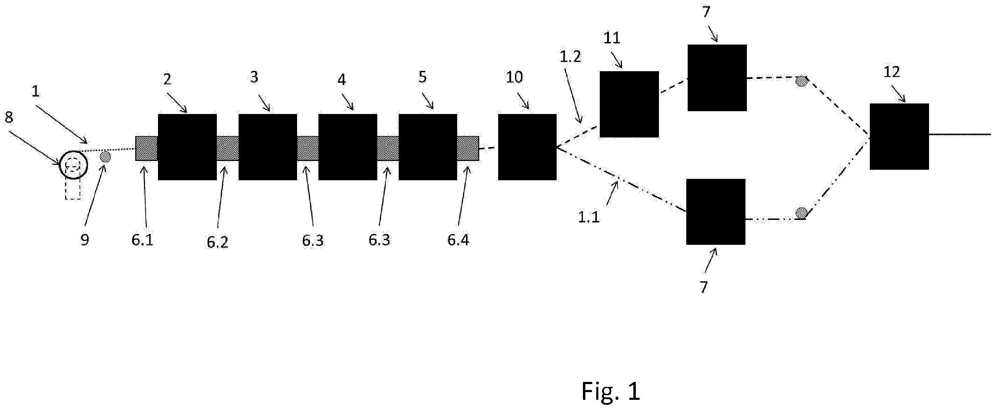

Bei dem in Figur 1 gezeigten Beispiel wird ein Metallband 1 von einer Rolle 8 abgewickelt und über eine Umlenkrolle 9 in eine erste Vorrichtung 2 zur Durchführung einer Grobreinigung eingeführt.

Von dort wird das Metallband 1 weiter in eine zweite Vorrichtung 3 gefördert, in der eine Feinreinigung und Nitrierung mittels Plasma durchgeführt wird. Das so behandelte Metallband 1 wird dann weiter in die dritte Vorrichtung 4 gefördert, in der eine Chromschicht zur Verbesserung der Haftung und als Korrosionsschutz auf Oberflächen des Metallbandes 1 ausgebildet wird.

In der vierten Vorrichtung 5 wird dann eine Kohlenstoffschicht ausgebildet.

Zumindest die zweite bis vierte Vorrichtung 3 bis 5 sollten einen Innendruck aufweisen, der kleiner als der Umgebungsdruck und für die Durchführung des jeweiligen Verfahrens in der jeweiligen Vorrichtung geeignet ist.

Zwischen den Vorrichtungen 2 bis 5 ist jeweils eine Schleuse vorhanden, wobei die Schleuse 6.2 den Übergang von der ersten Vorrichtung 2 mit zur bei diesem Beispiel zweiten Vorrichtung 3 mit Innendruck unterhalb des Umgebungsdruckes, die Schleusen 6.3 Übergänge zwischen der dritten Vorrichtung 4 mit vermindertem Innendruck und die Schleuse 6.4 den Übergang von einer vierten Vorrichtung 5 mit vermindertem Innendruck in Bezug zur Umgebungsatmosphäre herstellt. Eine Schleuse 6.1 ist auch vor der ersten Vorrichtung 2 vorhanden.

In Vorschubbewegungsrichtung des Metallbandes 1 nachfolgend an die vierte Vorrichtung 5 ist eine Einrichtung 10 angeordnet, mit der eine Teilung des Metallbandes 1 in zwei vorbehandelte Metallbänder 1.1 und 1.2 erreicht wird. Dabei kann das Metallband 1 bevorzugt mittig parallel zur Vorschubbewegungsachse des Metallbandes 1 getrennt werden.

Eines der zwei so erhaltenen vorbehandelten Metallbänder 1.2 wird einer Einrichtung 11 zugeführt, mit der es um 180 ° gedreht wird. Da in der Regel nur eine Oberfläche des Metallbandes vorbehandelt wird, erfolgt die Drehung so, dass die vorbehandelten Oberflächen der Metallbänder 1.1 und 1.2 nicht aufeinander zu weisen.

Jedes der Metallbänder 1.1 und 1.2 wird bei diesem Beispiel mindestens einer Umformvorrichtung 7 zugeführt und weiter gefördert. Nach der Umformung ist das Band nicht mehr planar sondern weißt eine wellige typischerweise dreidimensionale Oberfläche mit Vertiefungen oder auch Erhebungen auf.

Die Umformvorrichtung kann beispielsweise aus Prägewalzen bestehen, die so strukturiert sind, dass die Metallbänder 1.1 und 1.2 so verformt werden, dass Vertiefungen und bei Bedarf auch Erhebungen, in Form von Kanälen oder Hügeln für die Zu- und Abfuhr von Betriebsstoffen und Reaktionsprodukten und deren Verteilung innerhalb von Brennstoffzellen ausgebildet werden können. Hierbei bestehen die Walzen jeweils aus Paaren von denen eine die Matrize und eine die Patrize bilden.

Die so umgeformten Metallbänder 1.1 und 1.2 werden einer Einrichtung 12 zum stoffschlüssigen Fügen zugeführt, das bevorzugt mit Laserstrahlung erfolgen kann.

Im Nachgang dazu kann eine Vereinzelung und weitere Herstellung von Brennstoffzellen, wie im allgemeinen Teil der Beschreibung erläutert, durchgeführt werden.

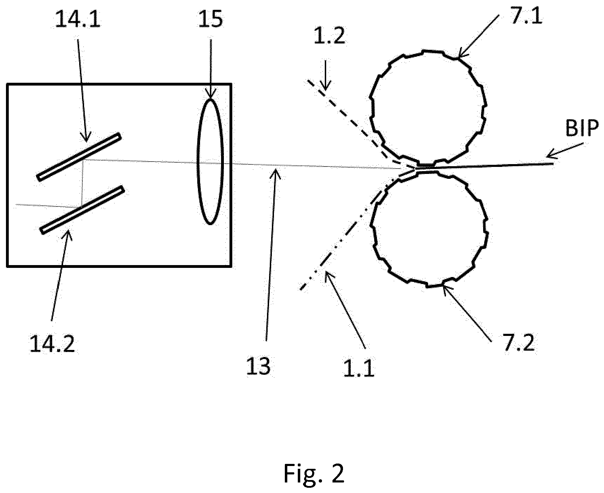

In Figur 2 ist gezeigt, wie zwei umgeformte und in geeigneter Form zueinander gedrehte Metallbänder 1.1 und 1.2, von denen eines die anodenseitige und eines die kathodenseitige Kanalstruktur aufweist, gemeinsam in den Spalt zwischen den zwei Walzen 7.1 und 7.2 bewegt werden. Bei der Drehung der Walzen 7.1 und 7.2 erfolgt auch eine Weiterbewegung.

Werden, durch die Walzen 7.1 und 7.2 Oberflächenbereiche der umgeformten Metallbänder 1.1 und 1.2 in berührenden Kontakt gebracht, an denen eine stoffschlüssige Verbindung hergestellt werden soll, wird ein Laserstrahl 13 in den Spalt zwischen den Walzen 7.1 und 7.2 auf aufeinander zu weisende Oberflächen der vorbehandelten und umgeformten Metallbänder 1.1 und 1.2 gerichtet, so dass an diesen Positionen eine stoffschlüssige Schweißverbindung hergestellt wird. An diesen Positionen treten Oberflächenbereiche der Metallbänder 1.1 und 1.2 in berührenden Kontakt miteinander. Die zwischen den Metallbändern 1.1 und 1.2 entstehende Kanalstruktur kann die Kühlkanäle bilden.

Der Laserstrahl 13 kann mit zwei reflektierenden Elementen 14.1 und 14.2, die einen Scanner oder auch Galvo-Scanner bilden, und mit denen er zu den jeweiligen Positionen, an denen stoffschlüssige Verbindungen ausgebildet werden sollen, ausgelenkt werden kann, auf die jeweiligen Positionen zum Herstellen der stoffschlüssigen Verbindung gerichtet. Mittels einer f-theta-Optik 15 kann die Brennweite und damit die Position der Brennpunktebene des Laserstrahls 13 definiert beeinflusst werden.

## Patentansprüche

1. Verfahren zur Herstellung für Bipolarplatten von Brennstoffzellen, bei denen an mindestens einer Seite mindestens einer der zwei Elektroden von Brennstoffzellen eine Bipolarplatte angeordnet und mit einer Membran-Elektroden-Anordnung elektrisch leitend verbindbar ist, wobei die einen Elektrolyten bildende Membran eine Polymermembran ist, bei dem
ein Metallband (1) oder zwei Metallbänder durch eine zweite Vorrichtung (3) und/oder eine dritte Vorrichtung (4) geführt wird/werden, wobei
die zweite Vorrichtung (3) zur Durchführung einer Feinreinigung und/oder einer Nitrierung des Metallbandes und
die dritte Vorrichtung (4) zur Durchführung einer Oberflächenbeschichtung an einer Seite einer Oberfläche mit einer eine Haftung verbessernden Metallschicht ausgebildet sind, und
auf die so behandelte Oberfläche eine Kohlenstoffschicht in einer vierten Vorrichtung (5) aufgebracht wird, und
im Anschluss daran eine Umformung der Metallbänder (1.1, 1.2) durchgeführt wird, bei der Kanäle für die Zufuhr von Brennstoff und Oxidationsmittel sowie die Abfuhr von Reaktionsprodukten der elektrochemischen Reaktionen ausgebildet werden, wobei
die dann umgeformten Metallbänder (1.1, 1.2) so aufeinander zu bewegt und positioniert werden, dass Oberflächenbereiche in denen eine stoffschlüssige Fügung erfolgen soll, in berührenden Kontakt miteinander gelangen und die Fügung mit mindestens einem Laserstrahl (13) ausgebildet wird und dabei
die einzelnen Schritte der in den Vorrichtungen (3, 4, 5), die Umformung und Fügung nacheinander in einem kontinuierlichen Durchlaufprozess durchgeführt werden,
**dadurch gekennzeichnet, dass**
der Laserstrahl (13) in einen Spalt zwischen den aufeinander zu bewegten umgeformten Metallbänder (1.1, 1.2) gerichtet und nur dort eine Schweißverbindung ausgebildet wird.

2. Verfahren nach Anspruch 1, **dadurch gekennzeichnet, dass** die zweite Vorrichtung (3), dritte Vorrichtung (4) und vierte Vorrichtung (5) unter gegenüber der Umgebung reduziertem Innendruck betrieben werden und durch Schleusen (6) von der Umgebung und/oder untereinander abgetrennt sind.

3. Verfahren nach einem der vorhergehenden Ansprüche, **dadurch gekennzeichnet, dass** ein Metallband (1) oder zwei Metallbänder in Förderrichtung vor der zweiten Vorrichtung (3) oder dritten Vorrichtung (4) durch eine erste Vorrichtung (2), die zur Vorreinigung des Metallbandes (1) oder der zwei Metallbänder (1.1, 1.2) ausgebildet ist, geführt werden.

4. Verfahren nach einem der vorhergehenden Ansprüche, **dadurch gekennzeichnet, dass** bei der Vorschubbewegung des einen so vorbehandelten Metallbandes (1) nach Ausbildung der Kohlenstoffschicht eine bevorzugt mittige Teilung in Vorschubachsrichtung und Drehung eines der geteilten Metallbänder (1.2) um 180 ° oder
eine Drehung eines von zwei so vorbehandelten Metallbändern (1.1, 1.2) um 180 ° durchgeführt wird.

5. Verfahren nach einem der vorhergehenden Ansprüche, **dadurch gekennzeichnet, dass** mit der vierten Vorrichtung (5) mittels einer nicht gepulsten lonenimplantierung bei hohen Ionenenergien eine Kohlenstoffschicht, die mit sp2- hybridisiertem Kohlenstoff gebildet ist, auf einer Oberfläche des einen Metallbandes (1) oder der zwei Metallbänder ausgebildet wird, wobei Ionenenergien größer als 100 eV eingehalten werden.

6. Verfahren nach einem der vorhergehenden Ansprüche, **dadurch gekennzeichnet, dass** die Vorreinigung nasschemisch oder mittels einer Wärmebehandlung, bei der Kohlenwasserstoffverbindungen oxidiert und dann die Oxidationsprodukte entfernt werden.

7. Verfahren nach einem der vorhergehenden Ansprüche, **dadurch gekennzeichnet, dass** die Feinreinigung und/oder die Nitrierung mit einem Plasma durchgeführt wird, wobei dabei das/die Metallband/Metallbänder auf eine Temperatur im Bereich 320 °C bis 450 °C erwärmt worden sind.

8. Verfahren nach einem der vorhergehenden Ansprüche, **dadurch gekennzeichnet, dass**
eine Haftschicht ausgebildet wird, in dem Metallionen, insbesondere Chromionen mittels eines Lichtbogenprozesses auf die zu beschichtende Oberfläche beschleunigt werden.

9. Verfahren nach einem der vorhergehenden Ansprüche, **dadurch gekennzeichnet, dass** für die Umformung der vorbehandelten Metallbändern (1.1, 1.2) mindestens zwei Umformwerkzeuge (7.1, 7.2) mindestens eines Werkzeugpaares, durch das die vorbehandelten Metallbänder hindurch bewegt werden und die aufeinander zu gewandten Oberflächen des Werkzeugpaares zur Umformung der vorbehandelten Metallbänder (1.1, 1.2) ausgebildet sind, eingesetzt werden.

10. Verfahren nach einem der vorhergehenden Ansprüche, **dadurch gekennzeichnet, dass** die Umformung der Metallbänder (1.1, 1.2) so durchgeführt wird, dass stoffschlüssig mit Laserstrahlung zu fügende Bereiche der Metallbänder (1.1, 1.2) entweder nicht oder so umgeformt werden, dass diese Oberflächenbereiche im Anschluss an die durchgeführte Umformung bei der Fügung so zueinander positioniert werden, dass sie in berührenden Kontakt zueinander gelangen und vor der Fügung ein Spalt zwischen den zu fügenden umgeformten Metallbändern (1.1, 1.2) ausgebildet ist, in den der mindestens eine Laserstrahl (13) auf die zu fügenden Oberflächenbereiche gerichtet werden kann.

11. Verfahren nach dem vorhergehenden Anspruch, **dadurch gekennzeichnet, dass** die Metallbänder (1.1, 1.2) mit mindestens einem Laserstrahl aus Richtung einer der beiden Metallbänder (1.1, 1.2) und mindestens im Randbereich der Bipolarplatte und der Medienzufuhr umsäumend gefügt werden.

12. Verfahren nach einem der vorhergehenden Ansprüche, **dadurch gekennzeichnet, dass** eine Nitrierung bei Temperaturen unterhalb 450 °C in einer Stickstoffatmosphäre in der zweiten Vorrichtung (3) über einen Zeitraum von maximal 5 Minuten durchgeführt wird.

13. Verfahren nach einem der vorhergehenden Ansprüche, **dadurch gekennzeichnet, dass** als ein Metallband (1) oder zwei Metallbänder aus einem Stahl oder Titan eingesetzt wird/werden.

14. Verfahren nach einem der vorhergehenden Ansprüche, **dadurch gekennzeichnet, dass** zwei Metallbänder (1.1, 1.2) in paralleler Ausrichtung zueinander und mit gleicher Geschwindigkeit durch die Vorrichtungen (2, 3, 4, 5) und eine Einrichtung (12) zur Fügung der Metallbänder bewegt werden, wobei bevorzugt diese Geschwindigkeit auch bei der Umformung und wenn erforderlich bei einer Bandwende oder - drehung beibehalten wird.

15. Verfahren nach einem der vorhergehenden Ansprüche, **dadurch gekennzeichnet, dass** in der zweiten Vorrichtung (3) oder einer weiteren Vorrichtung, die in Vorschubbewegungsrichtung des einen Metallbandes oder der zwei Metallbänder (1.1, 1.2) vor der vierten Vorrichtung (5) angeordnet ist, eine zusätzliche Carborierung unter Kohlenstoffzufuhr durchgeführt wird.

16. Verfahren nach einem der vorhergehenden Ansprüche, **dadurch gekennzeichnet, dass** Metallbänder (1.1, 1.2) mit unterschiedlicher Dicke eingesetzt werden.

## Claims

1. A method for producing bipolar plates for fuel cells, in which a bipolar plate is arranged on at least one side of at least one of the two electrodes of fuel cells and can be electrically conductively connected to a membrane-electrode assembly, wherein the membrane forming an electrolyte is a polymer membrane, wherein
one metal strip (1) or two metal strips is/are guided through a second device (3) and/or a third device (4), wherein
the second device (3) is designed to carry out fine cleaning and/or nitriding of the metal strip and
the third device (4) is designed to carry out surface coating on one side of a surface with a metal layer that improves adhesion, and
a carbon layer is applied to the surface thus treated in a fourth device (5), and
subsequently a shaping of the metal strips (1.1, 1.2) is carried out, in which channels are formed for the supply of fuel and oxidant and the removal of reaction products of the electrochemical reactions, wherein
the then shaped metal strips (1.1, 1.2) are moved towards one another and positioned in such a way that surface regions in which a material-bonded joint is to be formed come into direct contact with one another, and the joint is formed with at least one laser beam (13), and during this process
the individual steps n the devices (3, 4, 5), the shaping and the joining iare carried out one after the other in a continuous process,
**characterized in that**
the laser beam (13) is directed into a gap between the shaped metal strips (1.1, 1.2) moved towards one another and a welded joint is formed only there.

2. The method according to claim 1, **characterized in that** the second device (3), third device (4) and fourth device (5) are operated under reduced internal pressure relative to the environment and are separated from the environment and/or from one another by sluices (6).

3. The method according to one of the preceding claims, **characterized in that** a metal strip (1) or two metal strips are guided in the conveying direction upstream of the second device (3) or third device (4) through a first device (2) which is designed for precleaning the metal strip (1) or the two metal strips (1.1, 1.2).

4. The method according to one of the preceding claims, **characterized in that** during the feed movement of one of the metal strips (1) thus pretreated, after formation of the carbon layer, a preferably central division in the feed axis direction and rotation of one of the divided metal strips (1.2) by 180° or
a 180° rotation of one of two metal strips (1.1, 1.2) thus pretreated is carried out.

5. The method according to any one of the preceding claims, **characterized in that** a carbon layer formed with sp2 hybridized carbon is formed on a surface of the one metal strip (1) or the two metal strips by the fourth device (5) by means of non-pulsed ion implantation at high ion energies, wherein ion energies greater than 100 eV are maintained.

6. The method according to any one of the preceding claims, **characterized in that** the precleaning is carried out wet-chemically or by means of a heat treatment in which hydrocarbon compounds are oxidized and then the oxidation products are removed.

7. The method according to any one of the preceding claims, **characterized in that** the fine cleaning and/or the nitriding is carried out with a plasma, wherein the metal strip(s) has/have been heated to a temperature in the range 320 °C to 450 °C.

8. The method according to any one of the preceding claims, **characterized in that**
an adhesion layer is formed by accelerating metal ions, in particular chromium ions, onto the surface to be coated by means of an electric arc process.

9. The method according to one of the preceding claims, **characterized in that** at least two shaping tools (7.1, 7.2) of at least one tool pair, through which the pretreated metal strips are moved and the surfaces of the tool pair facing each other are formed for shaping the pretreated metal strips (1.1, 1.2), are used for shaping the pretreated metal strips (1.1, 1.2).

10. The method according to one of the preceding claims, **characterized in that** the shaping of the metal strips (1.1, 1.2) is carried out in such a way that regions of the metal strips (1.1, 1.2) to be joined by a material bond with laser radiation are either not shaped or are shaped in such a way that, following the shaping carried out, these surface regions are positioned with respect to one another during the joining in such a way that they come into direct contact with one another and, before the joining, a gap is formed between the shaped metal strips (1.1, 1.2) to be joined, into which gap the at least one laser beam (13) can be directed onto the surface regions to be joined.

11. The method according to the preceding claim, **characterized in that** the metal strips (1.1, 1.2) are circumferentially joined with at least one laser beam from the direction of one of the two metal strips (1.1, 1.2) and at least in the edge region of the bipolar plate and the media supply.

12. The method according to any one of the preceding claims, **characterized in that** a nitriding is carried out at temperatures below 450°C in a nitrogen atmosphere in the second device (3) for a period of time of at the most 5 minutes.

13. The method according to any one of the preceding claims, **characterized in that** as one metal strip (1) or two metal strips made of a steel or titanium is/are used.

14. The method according to one of the preceding claims, **characterized in that** two metal strips (1.1, 1.2) are moved in parallel alignment to each other and at the same speed through the devices (2, 3, 4, 5) and an apparatus (12) for joining the metal strips, preferably maintaining this speed also during shaping and, if necessary, during a strip turn or rotation.

15. The method according to one of the preceding claims, **characterized in that** in the second device (3) or in a further device which is arranged upstream of the fourth device (5) in the feed movement direction of the one metal strip or of the two metal strips (1.1, 1.2), an additional carburizing is carried out by adding carbon.

16. The method according to any one of the preceding claims, **characterized in that** metal strips (1.1, 1.2) of different thickness are used.

## Revendications

1. Procédé de fabrication de plaques bipolaires pour piles à combustible ayant une plaque bipolaire qui est agencée sur au moins un côté d'au moins une des deux électrodes de piles à combustible et qui peut être reliée de manière électriquement conductrice à un système membrane-électrodes, dans lequel la membrane formant un électrolyte est une membrane polymère, dans lequel
une bande métallique (1) ou deux bandes métalliques est/sont guidée(s) à travers un deuxième dispositif (3) et/ou un troisième dispositif (4), dans lequel
le deuxième dispositif (3) est conçu pour mettre en œuvre un nettoyage de précision et/ou une nitruration de la bande métallique et
le troisième dispositif (4) est conçu pour mettre en œuvre, sur un côté d'une surface, un traitement de surface comprenant l'application d'une couche métallique améliorant l'adhérence, et
une couche de carbone est appliquée par un quatrième dispositif (5) sur la surface ainsi traitée, et
une mise en forme des bandes métalliques (1.1, 1.2) est ensuite mise en œuvre, lors de laquelle sont créés des canaux destinés à l'alimentation en combustible et en agent oxydant ainsi qu'à l'évacuation des produits réactionnels issus des réactions électrochimiques, dans lequel
les bandes métalliques (1.1, 1.2) ainsi mises en forme sont déplacées et positionnées l'une par rapport à l'autre de sorte que les régions de surface dans lesquelles doit intervenir un assemblage par complémentarité de matière entrent en contact les unes avec les autres et l'assemblage est réalisé à l'aide d'au moins un faisceau laser (13), et dans lequel
les différentes étapes au sein des dispositifs (3, 4, 5), la mise en forme et l'assemblage sont mis en œuvre successivement au sein d'un processus pas à pas continu,
**caractérisé en ce que**
le faisceau laser (13) est dirigé dans un interstice situé entre les bandes métalliques (1.1, 1.2) mises en forme et déplacées l'une vers l'autre et un joint de soudure n'est réalisé qu'à cet endroit.

2. Procédé selon la revendication 1, **caractérisé en ce que** le deuxième dispositif (3), le troisième dispositif (4) et le quatrième dispositif (5) fonctionnent sous une pression interne réduite par rapport à l'environnement et sont séparés de l'environnement et/ou les uns des autres par des sas (6).

3. Procédé selon l'une quelconque des revendications précédentes, **caractérisé en ce qu'**une bande métallique (1) ou deux bandes métalliques est/sont guidée(s) dans le sens de transport avant le deuxième dispositif (3) ou le troisième dispositif (4) à travers un premier dispositif (2) conçu pour pré-nettoyer la bande métallique (1) ou les deux bandes métalliques (1.1, 1.2).

4. Procédé selon l'une quelconque des revendications précédentes, **caractérisé en ce que**, lors du déplacement d'alimentation de la bande métallique (1) ainsi prétraitée et après création de la couche de carbone, une division de préférence centrale dans le sens de l'axe d'alimentation et une rotation de 180° de l'une des bandes métalliques (1.2) divisées ou
une rotation de 180° de l'une des deux bandes métalliques (1.1, 1.2) ainsi prétraitées sont mises en œuvre.

5. Procédé selon l'une quelconque des revendications précédentes, **caractérisé en ce qu'**une couche de carbone formée de carbone hybridé sp2 est créée sur une surface de la bande métallique (1) ou des deux bandes métalliques grâce au quatrième dispositif (5) au moyen d'une implantation ionique non pulsée à des énergies ioniques élevées, dans lequel des énergies ioniques supérieures à 100 eV sont délivrées.

6. Procédé selon l'une quelconque des revendications précédentes, **caractérisé en ce que** le pré-nettoyage est réalisé par voie chimique humide ou au moyen d'un traitement thermique lors duquel les composés hydrocarbonés sont oxydés puis les produits d'oxydation sont éliminés.

7. Procédé selon l'une quelconque des revendications précédentes, **caractérisé en ce que** le nettoyage de précision et/ou la nitruration est/sont mis en œuvre avec un plasma, dans lequel la ou les bande(s) métallique(s) a/ont été chauffée(s) à une température située dans la plage comprise entre 320°C et 450°C.

8. Procédé selon l'une quelconque des revendications précédentes, **caractérisé en ce que**
une couche adhésive est créée en accélérant des ions métalliques, en particulier des ions de chrome, sur la surface à revêtir au moyen d'un procédé à arc électrique.

9. Procédé selon l'une quelconque des revendications précédentes, **caractérisé en ce qu'**au moins deux outils de mise en forme (7.1, 7.2), appartenant à au moins une paire d'outils à travers laquelle les bandes métalliques prétraitées sont déplacées, sont utilisés pour la mise en forme et les bandes métalliques (1.1, 1.2) prétraitées et les surfaces affrontées de la paire d'outils sont conçues pour mettre en forme les bandes métalliques (1.1, 1.2) prétraitées.

10. Procédé selon l'une quelconque des revendications précédentes, **caractérisé en ce que** la mise en forme des bandes métalliques (1.1, 1.2) est mise en œuvre de sorte que des régions des bandes métalliques (1.1, 1.2) à assembler par complémentarité de matière grâce à un rayonnement laser ne sont pas mises en forme, ou sont mises en forme de sorte que lesdites régions de surface, lors de l'assemblage succédant à la mise en forme, sont positionnées l'une par rapport à l'autre de sorte qu'elles entrent en contact l'une avec l'autre et qu'un interstice dans lequel au moins un faisceau laser (13) peut être dirigé vers les régions de surface à assembler est formé avant l'assemblage entre les bandes métalliques (1.1, 1.2) mises en forme et devant être assemblées.

11. Procédé selon la revendication précédente, **caractérisé en ce que** les bandes métalliques (1.1, 1.2) sont assemblées grâce à au moins un faisceau laser en provenance de l'une des deux bandes métalliques (1.1, 1.2) et en suivant au moins la région de bord de la plaque bipolaire et de l'alimentation en milieu.

12. Procédé selon l'une quelconque des revendications précédentes, **caractérisé en ce que** la nitration est mise en œuvre à des températures inférieures à 450 °C dans une atmosphère d'azote au sein du deuxième dispositif (3) pendant une période n'excédant pas 5 minutes.

13. Procédé selon l'une quelconque des revendications précédentes, **caractérisé en ce qu'**une ou deux bande(s) métallique(s) (1) en acier ou en titane est/sont utilisées.

14. Procédé selon l'une quelconque des revendications précédentes, **caractérisé en ce que** deux bandes métalliques (1.1, 1.2) sont déplacées parallèlement l'une à l'autre et à la même vitesse grâce aux dispositifs (2, 3, 4, 5) et à un dispositif (12) permettant d'assembler les bandes métalliques, dans lequel ladite vitesse est de manière préférée conservée également lors de la mise en forme et, si nécessaire, pendant un retournement ou une rotation de la bande.

15. Procédé selon l'une quelconque des revendications précédentes, **caractérisé en ce qu'**une carburation supplémentaire avec apport de carbone est mise en œuvre dans le deuxième dispositif (3) ou dans un autre dispositif agencé avant le quatrième dispositif (5) dans le sens d'alimentation de la bande métallique ou des deux bandes métalliques (1.1, 1.2).

16. Procédé selon l'une quelconque des revendications précédentes, **caractérisé en ce que** des bandes métalliques (1.1, 1.2) d'épaisseurs différentes sont utilisées.
